# EUROPEAN PATENT APPLICATION

(11) **EP 4 586 788 A1**
(43) Date of publication of application: **16.07.2025**
(21) Application number: 24219798.6
(22) Date of filing: 13.12.2024
(51) Int. Cl.: H10K 59/38, H10K 59/80

(54) **DISPLAY DEVICE**

(30) Priority: 15.01.2024 KR 20240005983
(71) Applicant: Samsung Display Co., Ltd., Yongin-si, Gyeonggi-do 17113 (KR)
(72) Inventor: Gil, El Ly, Yongin-si, Gyeonggi-do (KR); Jung, Soon Il, Yongin-si, Gyeonggi-do (KR)
(74) Representative: Gulde & Partner

(57) **Abstract**

A display device includes a plurality of pixels disposed in a display area, each of the pixels including a plurality of pixel electrodes spaced apart from each other, a first light blocking layer disposed in the display area and including a plurality of holes overlapping the plurality of pixel electrodes, a plurality of color filters disposed on the first light blocking layer and respectively corresponding to the plurality of holes, and a second light blocking layer disposed on the color filters and corresponding to the pixel electrodes of some of the plurality of pixels. The second light blocking layer surrounds the corresponding pixel electrodes of the some of the plurality of pixels in a plan view and includes a plurality of light blocking patterns having a constant width.

## Description

### TECHNICAL FIELD

Embodiments of the present disclosure relate to a display device.

### DISCUSSION OF RELATED ART

With the advance of information-oriented society, increased various demands are being placed on display devices that display images. For example, display devices are employed in various electronic devices such as smartphones, digital cameras, laptop computers, navigation devices, and smart televisions. The display device may be a flat panel display device such as a liquid crystal display device, a field emission display device, or an organic light emitting display device. Among the flat panel display devices, in the light emitting display device, since each of pixels of a display panel includes a light emitting element capable of emitting light by itself, an image can be displayed without a backlight unit providing light to the display panel.

### SUMMARY

Embodiments of the present disclosure provide a display device including a plurality of light blocking layers disposed in different layers.

Embodiments of the present disclosure also provide a display device capable of providing a privacy protection mode by including the light blocking layer disposed on some pixels.

According to an embodiment, a display device includes a plurality of pixels disposed a display area, each of the plurality of pixels including a plurality of pixel electrodes spaced apart from each other, a first light blocking layer disposed in the display area and including a plurality of holes overlapping the plurality of pixel electrodes, a plurality of color filters disposed on the first light blocking layer and respectively corresponding to the plurality of holes, and a second light blocking layer disposed on the color filters and corresponding to the pixel electrodes of some of the plurality of pixels. The second light blocking layer surrounds the corresponding pixel electrode of the some of the plurality of pixels in a plan view and includes a plurality of light blocking patterns each having a uniform width.

According to an embodiment, the plurality of pixel electrodes may comprise: a first pixel electrode and a second pixel electrode having a larger diameter than the first pixel electrode, the second light blocking layer comprises a first light blocking pattern corresponding to the first pixel electrode, and a second light blocking pattern corresponding to the second pixel electrode, and a separation distance between an outer side of the first pixel electrode and an inner side of the first light blocking pattern is about equal to a separation distance between an outer side of the second pixel electrode and an inner side of the second light blocking pattern.

According to an embodiment, the separation distance between the outer side of the first pixel electrode and the inner side of the first light blocking pattern may range from about 1 µm to about 3 µm.

According to an embodiment, the first light blocking pattern and the second light blocking pattern may have about a same width, and an inner diameter from a center of the first pixel electrode to the inner side of the first light blocking pattern may be larger than an inner diameter from a center of the second pixel electrode to the inner side of the second light blocking pattern.

According to an embodiment, an outer diameter from the center of the first pixel electrode to an outer side of the first light blocking pattern may be larger than an outer diameter from the center of the second pixel electrode to an outer side of the second light blocking pattern.

According to an embodiment, the plurality of pixel electrodes may comprise a first pixel electrode and a second pixel electrode having a larger diameter than the first pixel electrode, the second light blocking layer may comprise a first light blocking pattern corresponding to the first pixel electrode, and a second light blocking pattern corresponding to the second pixel electrode, and a separation distance between an outer side of the first pixel electrode and an inner side of the first light blocking pattern may be different from a separation distance between an outer side of the second pixel electrode and an inner side of the second light blocking pattern.

According to an embodiment, the separation distance between the outer side of the first pixel electrode and the inner side of the first light blocking pattern may be smaller than the separation distance between the outer side of the second pixel electrode and the inner side of the second light blocking pattern.

According to an embodiment, the first light blocking pattern and the second light blocking pattern may have about a same width, an inner diameter from a center of the first pixel electrode to the inner side of the first light blocking pattern may be about equal to an inner diameter from a center of the second pixel electrode to the inner side of the second light blocking pattern, and an outer diameter from the center of the first pixel electrode to an outer side of the first light blocking pattern is about equal to an outer diameter from the center of the second pixel electrode to an outer side of the second light blocking pattern.

According to an embodiment, the plurality of light blocking patterns may be directly connected to each other.

According to an embodiment, the second light blocking layer may comprise a transmission portion overlapping the corresponding pixel electrodes of the some of the plurality of pixels, and the transmission portion of the second light blocking layer may overlap the holes of the first light blocking layer.

According to an embodiment, a diameter of the transmission portion of the second light blocking layer may be larger than a diameter of a corresponding one of the holes of the first light blocking layer.

According to an embodiment, the plurality of pixels may comprise a first pixel in which the second light blocking layer is not disposed, and a second pixel in which the light blocking patterns are respectively disposed and correspond to the pixel electrodes.

According to an embodiment, a diameter of one of the holes of the first light blocking layer in the first pixel may be larger than a diameter one of the holes of the first light blocking layer in the second pixel.

According to an embodiment, a difference between a diameter of one of the pixel electrodes in the first pixel and the diameter of the one of the holes of the first light blocking layer in the first pixel may be greater than a difference between a diameter of one of the pixel electrodes in the second pixel and the diameter of the one of the holes of the first light blocking layer in the second pixel.

According to an embodiment, a thickness of each of the first light blocking layer and the second light blocking layer may range from about 1 µm to about 3 µm.

According to an embodiment, a display device includes a first pixel and a second pixel disposed on a substrate, each of the first and second pixels including a plurality of pixel electrodes, an encapsulation layer disposed on the pixel electrodes, a first light blocking layer disposed on the encapsulation layer and including a plurality of holes respectively corresponding to the pixel electrodes, a plurality of color filters disposed on the first light blocking layer and respectively corresponding to the pixel electrodes, a passivation layer disposed on the color filters and the first light blocking layer, a second light blocking layer disposed on the passivation layer in the second pixel and including a plurality of light blocking patterns forming a plurality of transmission portions respectively corresponding to the pixel electrodes of the second pixel, and an overcoat layer disposed on the second light blocking layer. A diameter of each of the transmission portions of the second light blocking layer is larger than a diameter of a corresponding one of the holes of the first light blocking layer.

According to an embodiment, each of the holes of the first light blocking layer may overlap a corresponding one of the pixel electrodes, and a diameter of one of the holes of the first light blocking layer in the first pixel may be larger than a diameter of one of the holes of the first light blocking layer in the second pixel.

According to an embodiment, the plurality of pixel electrodes may have different diameters, and in the second pixel, differences between diameters of the different pixel electrodes and diameters of the transmission portions of different light blocking patterns may be about equal to each other.

According to an embodiment, the plurality of pixel electrodes may have different diameters, and in the second pixel, differences between diameters of the different pixel electrodes and diameters of the transmission portions of the different light blocking patterns may be different from each other.

According to an embodiment, the second pixel may comprise a first pixel electrode and a second pixel electrode having a larger diameter than the first pixel electrode, the second light blocking layer may comprise a first light blocking pattern forming a first transmission portion overlapping the first pixel electrode, and a second light blocking pattern forming a second transmission portion overlapping the second pixel electrode, and a difference between a diameter of the first pixel electrode and a diameter of the first transmission portion may be smaller than a difference between a diameter of the second pixel electrode and a diameter of the second transmission portion.

According to an embodiment, a display device includes a plurality of light blocking layers, and the light blocking layers have a shape that corresponds to and surrounds a pixel electrode. The display device adjusts the shape of light blocking patterns of the light blocking layer and the separation distance from the pixel electrode. As a result, a display screen may be visually recognized only by a user looking from a front surface of a display area, and the screen is not visually recognized by a user looking at a specific viewing angle or from the side. The display device may provide a privacy protection mode to the user.

### BRIEF DESCRIPTION OF THE DRAWINGS

The above and other aspects and features of the present disclosure will become more apparent by describing in detail embodiments thereof with reference to the accompanying drawings, in which:
FIG. 1 is a schematic perspective view of an electronic device according to an embodiment;
FIG. 2 is a perspective view illustrating a display device included in an electronic device according to an embodiment;
FIG. 3 is a cross-sectional view of the display device of FIG. 2 viewed from the side;
FIG. 4 is a plan view of the disposition of pixel electrodes in the display area of the display device according to an embodiment;
FIG. 5 is a plan view illustrating the disposition of a pixel electrode, a first light blocking layer, and color filters in the display area of the display device according to an embodiment;
FIG. 6 is a plan view illustrating the disposition of a pixel electrode and a second light blocking layer in the display area of the display device according to an embodiment;
FIG. 7 is a schematic diagram illustrating light emitting pixels according to an emission mode of the display device according to an embodiment;
FIG. 8 is a cross-sectional view taken along line X1-X1' of FIGS. 5 and 6;
FIG. 9 is a cross-sectional view taken along line X2-X2' of FIGS. 5 and 6;
FIG. 10 is a cross-sectional view taken along lines X3-X3' and X4-X4' of FIGS. 5 and 6;
FIG. 11 is a diagram illustrating the relative disposition of a second light blocking layer and a pixel electrode disposed in one pixel of the display device according to an embodiment;
FIG. 12 is a diagram illustrating the relative disposition of a second light blocking layer and a pixel electrode disposed in one pixel of a display device according to an embodiment; and
FIGS. 13 and 14 are views showing a second light blocking layer of a display device according to an embodiment.

### DETAILED DESCRIPTION OF THE EMBODIMENTS

Embodiments of the present disclosure will be described more fully hereinafter with reference to the accompanying drawings. Like reference numerals may refer to like elements throughout the accompanying drawings.

It will be understood that the terms "first," "second," "third," etc. are used herein to distinguish one element from another, and the elements are not limited by these terms. Thus, a "first" element in an embodiment may be described as a "second" element in another embodiment.

It should be understood that descriptions of features or aspects within each embodiment should typically be considered as available for other similar features or aspects in other embodiments, unless the context clearly indicates otherwise.

As used herein, the singular forms "a", "an" and "the" are intended to include the plural forms as well, unless the context clearly indicates otherwise.

Spatially relative terms, such as "beneath", "below", "lower", "under", "above", "upper", "inner", "outer", etc., may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the exemplary terms "below" and "under" can encompass both an orientation of above and below.

It will be understood that when a component such as a film, a region, a layer, etc., is referred to as being "on", "connected to", "coupled to", or "adjacent to" another component, it can be directly on, connected, coupled, or adjacent to the other component, or intervening components may be present. It will also be understood that when a component is referred to as being "between" two components, it can be the only component between the two components, or one or more intervening components may also be present. It will also be understood that when a component is referred to as "covering" another component, it can be the only component covering the other component, or one or more intervening components may also be covering the other component. Other words used to describe the relationships between components should be interpreted in a like fashion.

Herein, when two or more elements or values are described as being substantially the same as or about equal to each other, it is to be understood that the elements or values are identical to each other, the elements or values are equal to each other within a measurement error, or if measurably unequal, are close enough in value to be functionally equal to each other as would be understood by a person having ordinary skill in the art. For example, the term "about" as used herein is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations as understood by one of the ordinary skill in the art. Further, it is to be understood that while parameters may be described herein as having "about" a certain value, according to embodiments, the parameter may be exactly the certain value or approximately the certain value within a measurement error as would be understood by a person having ordinary skill in the art. Other uses of these terms and similar terms to describe the relationships between components should be interpreted in a like fashion.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

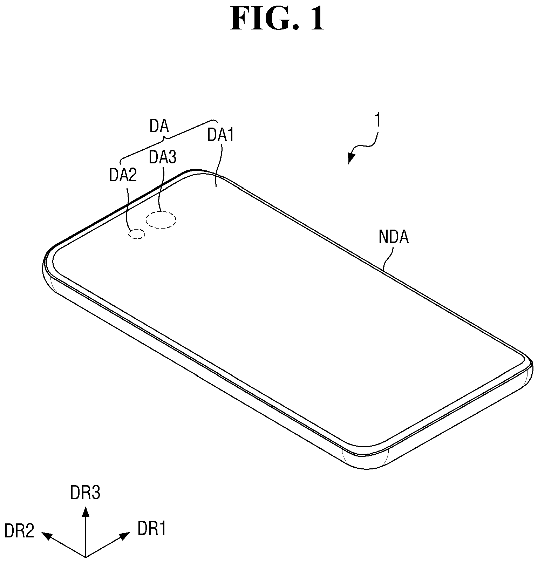

FIG. 1 is a schematic perspective view of an electronic device according to an embodiment.

Referring to FIG. 1, an electronic device 1 displays a moving image (e.g., a video) or a still image. The electronic device 1 may refer to any electronic device including a display screen that provides visual information to a user. Examples of the electronic device 1 may include a television, a laptop computer, a monitor, a billboard, an Internet-of-Things device, a mobile phone, a smartphone, a tablet personal computer (PC), an electronic watch, a smartwatch, a watch phone, a head-mounted display, a mobile communication terminal, an electronic notebook, an electronic book, a portable multimedia player (PMP), a navigation device, a game machine, a digital camera, a camcorder and the like, which include a display screen that provides visual information to a user.

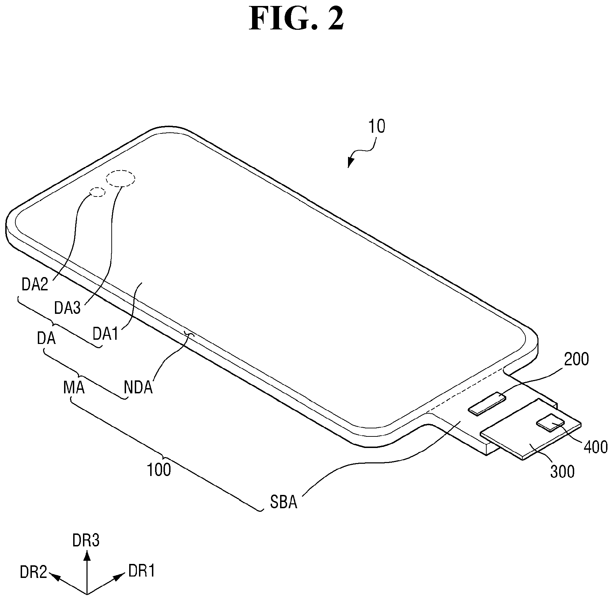

The electronic device 1 may include a display device 10, as shown in FIG. 2, including a display screen. Examples of the display device may include an inorganic light emitting diode display device, an organic light emitting display device, a quantum dot light emitting display device, a plasma display device and a field emission display device. In the following description, a case where an organic light emitting diode display device is applied as a display device will be exemplified, but the present disclosure is not limited thereto, and other display devices may be applied according to embodiments of the present disclosure.

The shape of the electronic device 1 may be variously modified. For example, the electronic device 1 may have a shape such as a rectangular shape elongated in a horizontal direction, a rectangular shape elongated in a vertical direction, a square shape, a quadrilateral shape with rounded corners (vertices), other polygonal shapes and a circular shape. The shape of a display area DA of the electronic device 1 may also be similar to the overall shape of the electronic device 1. FIG. 1 illustrates the electronic device 1 having a rectangular shape elongated in a second direction DR2.

The electronic device 1 may include the display area DA and a non-display area NDA. The display area DA is an area where a display screen can provide visual data, and the non-display area NDA is an area where image data is not displayed. The display area DA may also be referred to as an active region, and the non-display area NDA may also be referred to as a non-active region. The display area DA may substantially occupy the center of the electronic device 1.

The display area DA may include a first display area DA1, a second display area DA2, and a third display area DA3. The second display area DA2 and the third display area DA3 are areas in which components for adding various functions to the electronic device 1 are disposed. For example, the second display area DA2 and the third display area DA3 may correspond to a component area.

FIG. 2 is a perspective view illustrating a display device included in an electronic device according to an embodiment.

Referring to FIG. 2, the electronic device 1 according to an embodiment may include the display device 10. The display device 10 may provide an image displayed by the electronic device 1. The display device 10 may have a planar shape similar to the shape of the electronic device 1. For example, the display device 10 may have a shape similar to a rectangular shape having a short side in a first direction DR1 and a long side in the second direction DR2. The edge where the short side in the first direction DR1 and the long side in the second direction DR2 meet may be rounded to have a curvature, but is not limited thereto and may be formed at a right angle. The planar shape of the display device 10 is not limited to a quadrilateral shape, and may be formed in a shape similar to another polygonal shape, a circular shape, or elliptical shape.

The display device 10 may include a display panel 100, a display driver 200, a circuit board 300, and a touch driver 400.

The display panel 100 may include a main region MA and a sub-region SBA.

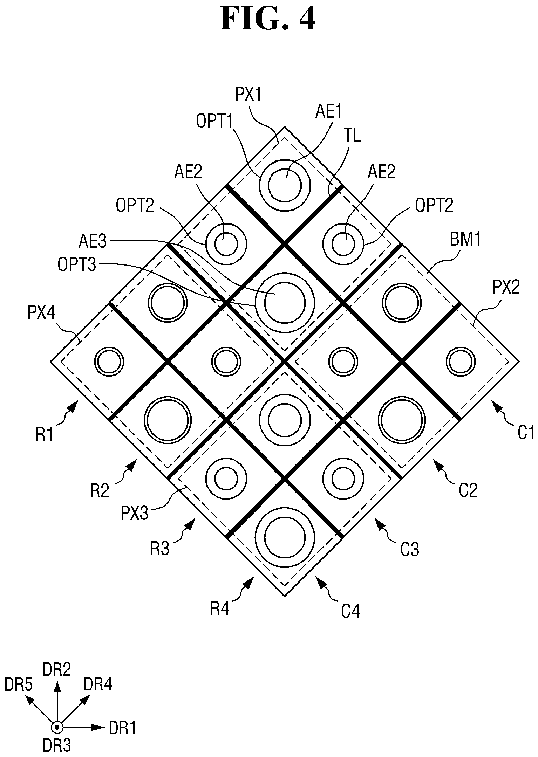

The main region MA may include the display area DA including pixels PX1, PX2, PX3, and PX4 (see FIG. 4) that display images, and the non-display area NDA disposed around the display area DA. The display area DA may be disposed in the center of the main region MA, and the non-display area NDA may surround the display area DA. The display area DA may include the first display area DA1, the second display area DA2, and the third display area DA3. The display area DA may emit light from a plurality of emission areas or a plurality of opening areas. For example, the display panel 100 may include a pixel circuit including switching elements, a pixel defining layer defining an emission area or an opening area, and a self-light emitting element.

For example, the self-light emitting element may include at least one of an organic light emitting diode (LED) including an organic light emitting layer, a quantum dot LED including a quantum dot light emitting layer, an inorganic LED including an inorganic semiconductor, or a micro LED, but is not limited thereto.

The non-display area NDA may be an area disposed outside the display area DA. The non-display area NDA may be defined as an edge area of the main region MA of the display panel 100. The non-display area NDA may include a gate driver that supplies gate signals to the gate lines, and fan-out lines that connect the display driver 200 to the display area DA.

The sub-region SBA may be a region extending from one side of the main region MA. The sub-region SBA may include a flexible material which can be bent, folded or rolled. For example, when the sub-region SBA is bent, the sub-region SBA may overlap the main region MA in a thickness direction (third direction DR3). The sub-region SBA may include the display driver 200 and a pad portion connected to the circuit board 300. In an embodiment, the sub-region SBA may be omitted, and the display driver 200 and the pad portion may be arranged in the non-display area NDA.

The display driver 200 may output signals and voltages that drive the display panel 100. The display driver 200 may supply data voltages to data lines. The display driver 200 may supply a power voltage to the power line and may supply a gate control signal to the gate driver. The display driver 200 may be formed as an integrated circuit (IC) and mounted on the display panel 100 by, for example, a chip on glass (COG) method, a chip on plastic (COP) method, or an ultrasonic bonding method. In an embodiment, the display driver 200 may be disposed in the sub-region SBA, and may overlap the main region MA in the thickness direction by bending of the sub-region SBA. In an embodiment, the display driver 200 may be mounted on the circuit board 300.

The circuit board 300 may be attached to the pad portion of the display panel 100 by using an anisotropic conductive film (ACF). Lead lines of the circuit board 300 may be electrically connected to the pad portion of the display panel 100. The circuit board 300 may be, for example, a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit and may sense an amount of change in capacitance between the plurality of touch electrodes. For example, the touch driving signal may be a pulse signal having a predetermined frequency. The touch driver 400 may calculate whether an input is made and input coordinates based on an amount of change in capacitance between the plurality of touch electrodes. The touch driver 400 may be formed as an integrated circuit (IC).

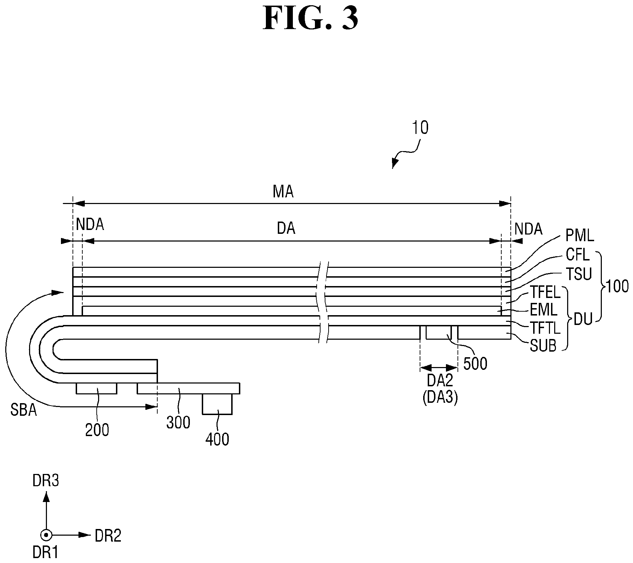

FIG. 3 is a cross-sectional view of the display device of FIG. 2 viewed from the side. FIG. 3 illustrates the sub-region SBA of the display panel 100 in the display device 10 of FIG. 2 in a folded state.

Referring to FIG. 3, the display panel 100 may include a display layer DU, a touch sensing layer TSU, a color filter layer CFL, and a light blocking member layer PML. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate which can be bent, folded or rolled. For example, the substrate SUB may include a polymer resin such as polyimide (PI), but is not limited thereto. In an embodiment, the substrate SUB may include a glass material or a metal material.

The thin film transistor layer TFTL may be disposed on the substrate SUB. The thin film transistor layer TFTL may include a plurality of thin film transistors constituting a pixel circuit of pixels. The thin film transistor layer TFTL may further include gate lines, data lines, power lines, gate control lines, fan-out lines that connect the display driver 200 to the data lines, and lead lines that connect the display driver 200 to the pad portion. Each of the thin film transistors may include a semiconductor region, a source electrode, a drain electrode, and a gate electrode. For example, when the gate driver is formed on one side of the non-display area NDA of the display panel 100, the gate driver may include thin film transistors.

The thin film transistor layer TFTL may be disposed in the display area DA, the non-display area NDA, and the sub-region SBA. Thin film transistors, gate lines, data lines, and power lines of each of the pixels of the thin film transistor layer TFTL may be disposed in the display area DA. Gate control lines and fan-out lines of the thin film transistor layer TFTL may be disposed in the non-display area NDA. The lead lines of the thin film transistor layer TFTL may be disposed in the sub-region SBA.

The light emitting element layer EML may be disposed on the thin film transistor layer TFTL. The light emitting element layer EML may include a plurality of light emitting elements each including a first electrode, a second electrode, and a light emitting layer that emits light, and a pixel defining layer defining pixels. The plurality of light emitting elements of the light emitting element layer EML may be disposed in the display area DA.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives the cathode voltage, holes and electrons may be transferred to the organic light emitting layer through the hole transporting layer and the electron transporting layer, respectively, and may be combined with each other to emit light in the organic light emitting layer.

In an embodiment, the light emitting elements may include a quantum dot light emitting diode including a quantum dot light emitting layer, an inorganic light emitting diode including an inorganic semiconductor, or a micro light emitting diode.

The encapsulation layer TFEL may cover the top surface and the side surface of the light emitting element layer EML, and may protect the light emitting element layer EML. The encapsulation layer TFEL may include at least one inorganic layer and at least one organic layer that encapsulate the light emitting element layer EML.

The touch sensing layer TSU may be disposed on the encapsulation layer TFEL. The touch sensing layer TSU may include a plurality of touch electrodes that sense a user's touch in a capacitive manner, and touch lines connecting the plurality of touch electrodes to the touch driver 400. For example, the touch sensing layer TSU may sense the user's touch by using a mutual capacitance method or a self-capacitance method.

In an embodiment, the touch sensing layer TSU may be disposed on a separate substrate disposed on the display layer DU. In this case, the substrate supporting the touch sensing layer TSU may be a base member that encapsulates the display layer DU.

The plurality of touch electrodes of the touch sensing layer TSU may be disposed in a touch sensor area overlapping the display area DA. The touch lines of the touch sensing layer TSU may be disposed in a touch peripheral area that overlaps the non-display area NDA.

The color filter layer CFL may be disposed on the touch sensing layer TSU. The color filter layer CFL may include a plurality of color filters respectively corresponding to the plurality of emission areas. Each of the color filters may selectively transmit light of a specific wavelength and may block or absorb light of a different wavelength. The color filter layer CFL may absorb a part of light coming from the outside of the display device 10 to reduce reflected light due to external light. Accordingly, the color filter layer CFL may prevent color distortion caused by reflection of the external light.

Since the color filter layer CFL is directly disposed on the touch sensing layer TSU, the display device 10 may not utilize a separate substrate for the color filter layer CFL. Accordingly, the thickness of the display device 10 may be relatively small.

The light blocking member layer PML may be disposed on the color filter layer CFL. The light blocking member layer PML may include light blocking patterns disposed to correspond to specific pixels of the display layer DU. The display device 10 may further include the light blocking member layer PML to control visibility at a specific viewing angle and provide a privacy protection mode to the user.

In some embodiments, the display device 10 may further include an optical device 500. The optical device 500 may be disposed in the second display area DA2 or the third display area DA3. The optical device 500 may emit or receive light in infrared, ultraviolet, and visible light bands. For example, the optical device 500 may be an optical sensor that detects light incident on the display device 10 such as a proximity sensor, an illuminance sensor, and a camera sensor or an image sensor.

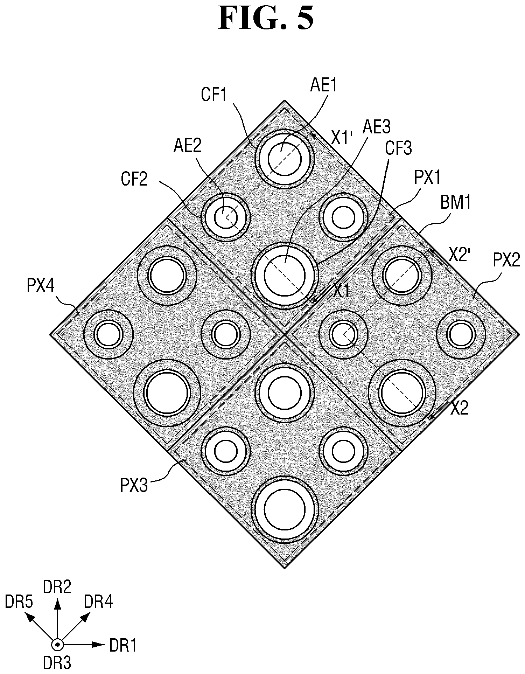

FIG. 4 is a plan view of the disposition of pixel electrodes in the display area of the display device according to an embodiment. FIG. 5 is a plan view illustrating the disposition of a pixel electrode, a first light blocking layer, and color filters in the display area of the display device according to an embodiment.

Referring to FIGS. 4 and 5, the display device 10 may include a plurality of pixels PX1, PX2, PX3, and PX4 disposed in the display area DA. The plurality of pixels PX1, PX2, PX3, and PX4 may be arranged in a fourth direction DR4 and a fifth direction DR5, which are diagonal directions between the first direction DR1 and the second direction DR2. The first pixel PX1 and the second pixel PX2 may be disposed adjacent to each other in the fifth direction DR5, and the second pixel PX2 and the third pixel PX3 may be disposed adjacent to each other in the fourth direction DR4. The third pixel PX3 and the fourth pixel PX4 may be disposed adjacent to each other in the fifth direction DR5. A plurality of pixels PX1, PX2, PX3, and PX4 may be repeatedly disposed in the arrangement of FIG. 4 across the entirety of the display area DA.

Each of the plurality of pixels PX1, PX2, PX3, and PX4 may include a plurality of pixel electrodes AE1, AE2, and AE3. For example, each of the plurality of pixels PX1, PX2, PX3, and PX4 may include the first pixel electrode AE1, the second pixel electrode AE2, and the third pixel electrode AE3. One pixel PX1, PX2, PX3, PX4 may include one first pixel electrode AE1, two second pixel electrodes AE2, and one third pixel electrode AE3. However, the present disclosure is not limited thereto. For example, the number of the pixel electrodes AE1, AE2, and AE3 disposed in the pixels PX1, PX2, PX3, and PX4 may be variously modified.

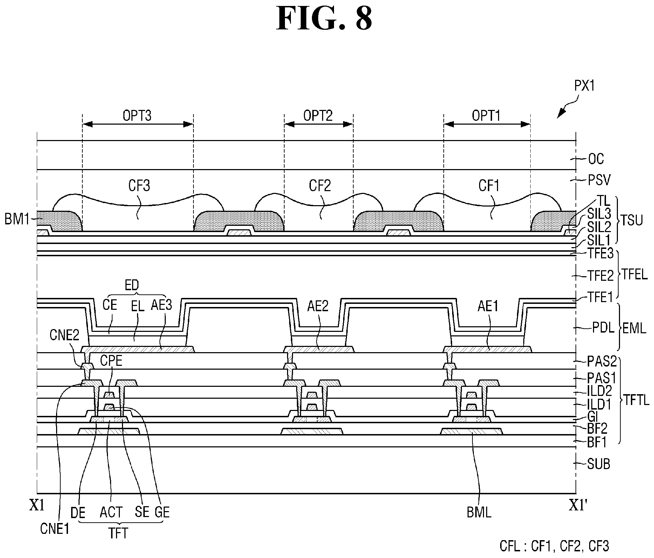

One pixel electrode AE1, AE2, AE3 may be an anode electrode of a light emitting element included in each of the pixels PX1, PX2, PX3, and PX4. One pixel PX1, PX2, PX3, PX4 may include one or more light emitting elements ED (see FIG. 8), and the light emitting elements may be light emitting elements that emit light of different colors. For example, a light emitting element including the first pixel electrode AE1 may emit first light of a red color. A light emitting element including the second pixel electrode AE2 may emit second light of a green color, and a light emitting element including the third pixel electrode AE3 may emit third light of a blue color. However, the present disclosure is not limited thereto. One first pixel electrode AE1, two second pixel electrodes AE2, and one third pixel electrode AE3 may form one pixel PX1, PX2, PX3, PX4 and may emit different colors and express a white grayscale. However, the present disclosure is not limited thereto, and the combination of the pixel electrodes AE1, AE2, and AE3 constituting one pixel PX1, PX2, PX3, PX4 may be modified in various ways depending on the arrangement of the pixel electrodes AE1, AE2, and AE3, the color of light that the pixel electrodes AE1, AE2, and AE3 emit, and the like.

Each of the pixel electrodes AE1, AE2, and AE3 may form an emission area in each of the pixels PX1, PX2, PX3, and PX4. For example, the first pixel electrode AE1 may form a first emission area that emits light of the first color, the second pixel electrode AE2 may form a second emission area that emits light of the second color, and the third pixel electrode AE3 may form a third emission area that emits light of the third color. In an embodiment, the emission area of the display device 10 may be an area overlapping the pixel electrodes AE1, AE2, and AE3, and for example, an opening of a pixel defining layer PDL (see FIG. 8) illustrated in FIG. 8 may correspond to the emission area. For example, each of the emission areas may be defined by a plurality of openings formed in the pixel defining layer PDL (see FIG. 8) of the light emitting element layer EML, which will be described in further detail below. The first emission area may be defined by a first opening overlapping the first pixel electrode AE1 in the pixel defining layer, the second emission area may be defined by a second opening overlapping the second pixel electrode AE2 in the pixel defining layer, and the third emission area may be defined by a third opening overlapping the third pixel electrode AE3 in the pixel defining layer.

The plurality of pixel electrodes AE1, AE2, and AE3 may be arranged in a PenTile^{™} type, e.g., a diamond PenTile^{™} type. For example, the first pixel electrode AE1 and the third pixel electrode AE3 may be spaced apart from each other in the second direction DR2, and may be alternately arranged in the first direction DR1 and the second direction DR2. The second pixel electrode AE2 may be spaced apart from another adjacent second pixel electrode AE2 in the first direction DR1 and the second direction DR2, and may be spaced apart from the adjacent first pixel electrode AE1 and the adjacent third pixel electrode AE3 in the fourth direction DR4 or the fifth direction DR5. The plurality of second pixel electrodes AE2 may be repeatedly arranged along the first direction DR1 and the second direction DR2, and the second pixel electrode AE2 and the first pixel electrode AE1, or the second pixel electrode AE2 and the third pixel electrode AE3, may be alternately arranged along the fourth direction DR4 or the fifth direction DR5.

In an embodiment, the areas or sizes of the first to third pixel electrodes AE1, AE2, and AE3 may be different from each other. In an embodiment according to FIG. 4, the area of the third pixel electrode AE3 may be larger than those of the first pixel electrode AE1 and the second pixel electrode AE2, and the area of the first pixel electrode AE1 may be larger than that of the second pixel electrode AE2. The intensity of light to be emitted may vary depending on the area of the emission area overlapping the pixel electrodes AE1, AE2, and AE3, and the area of the emission area may be adjusted to control the color of the screen displayed on the display device 10 or the electronic device 1. In an embodiment according to FIG. 4, the third pixel electrode AE3 has the largest area, but is not limited thereto. The size of the pixel electrodes AE1, AE2, and AE3 and the area of the emission area may be freely adjusted according to the color of the screen utilized for the display device 10 and the electronic device 1. In addition, the areas of the pixel electrodes AE1, AE2, and AE3 may be related to light efficiency and the lifespan of the light emitting element ED, and may have a trade-off relation with the reflection by external light. The areas of the pixel electrodes AE1, AE2, and AE3 may be adjusted in consideration of the above factors.

The display device 10 may include a first light blocking layer BM1 and a plurality of color filters CF1, CF2, and CF3 disposed on the pixel electrodes AE1, AE2, and AE3.

The first light blocking layer BM1 may be disposed over the entire display area DA. The first light blocking layer BM1 may include a plurality of holes OPT1, OPT2, and OPT3 respectively disposed to correspond to the plurality of pixel electrodes AE1, AE2, and AE3. Alternatively, each of the holes OPT1, OPT2, and OPT3 of the first light blocking layer BM1 may be disposed to correspond to the opening of the pixel defining layer PDL (see FIG. 8). The first light blocking layer BM1 may cover the display area DA except for an area where the holes OPT1, OPT2, and OPT3 are disposed in the display area DA. The holes OPT1, OPT2, and OPT3 of the first light blocking layer BM1 may be areas where light emitted from the light emitting element including the pixel electrodes AE1, AE2, and AE3 is emitted. The plurality of holes OPT1, OPT2, and OPT3 may include a first hole OPT1 overlapping the first pixel electrode AE1, a second hole OPT2 overlapping the second pixel electrode AE2, and a third hole OPT3 overlapping the third pixel electrode AE3. One first hole OPT1, two second holes OPT2, and one third hole OPT3 may be formed in the first light blocking layer BM1 within the area occupied by one pixel PX.

The area in a plan view of each of the plurality of holes OPT1, OPT2, and OPT3 may be larger than the area in a plan view of each of the pixel electrodes AE1, AE2, and AE3. For example, the first hole OPT1 may have a larger area in a plan view than the first pixel electrode AE1. The second hole OPT2 and the third hole OPT3 may also have larger areas in a plan view than the second pixel electrode AE2 and the third pixel electrode AE3, respectively. Further, each of the holes OPT1, OPT2, and OPT3 of the first light blocking layer BM1 may have a different area in a plan view. As described above, the areas of the plurality of pixel electrodes AE1, AE2, and AE3 may be different from each other, and accordingly, the sizes of the holes OPT1, OPT2, and OPT3 in the first light blocking layer BM1 may also be different from each other. For example, the diameter or size of the third hole OPT3 may be larger than that of the first hole OPT1 and the second hole OPT2, and the diameter or size of the first hole OPT1 may be larger than that of the second hole OPT2. However, the present disclosure is not limited thereto.

In some embodiments, the difference between the diameter of the pixel electrodes AE1, AE2, and AE3 and the diameter of the holes OPT1, OPT2, and OPT3 of the first light blocking layer BM1, or the separation distance between the outer side of the pixel electrodes AE1, AE2, and AE3 and the inner side of the holes OPT1, OPT2, and OPT3, may be uniform regardless of the type of the pixel electrodes AE1, AE2, and AE3 or the holes OPT1, OPT2, and OPT3. For example, the separation distance between the first pixel electrode AE1 and the first hole OPT1, or the difference between the diameter of the first pixel electrode AE1 and the diameter of the first hole OPT1, may be about equal to the separation distance between the second pixel electrode AE2 and the second hole OPT2, or the difference between the diameter of the second pixel electrode AE2 and the diameter of the second hole OPT2. This may also be about equal to the separation distance between the third pixel electrode AE3 and the third hole OPT3, or the difference between the diameter of the third pixel electrode AE3 and the diameter of the third hole OPT3. However, the present disclosure is not limited thereto, and depending on the type of the pixel electrodes AE1, AE2, and AE3, the separation distances between the pixel electrodes AE1, AE2, and AE3 and the holes OPT1, OPT2, and OPT3 of the first light blocking layer BM1 may be different.

According to an embodiment, the display device 10 may include the pixels PX1, PX2, PX3, and PX4 having different separation distances between the pixel electrodes AE1, AE2, and AE3 and the holes OPT1, OPT2, and OPT3 of the first light blocking layer BM1. For example, in the first pixel PX1 and the third pixel PX3, the separation distances between the pixel electrodes AE1, AE2, and AE3 and the holes OPT1, OPT2, and OPT3 of the first light blocking layer BM1 may be about equal to each other. Also, in the second pixel PX2 and the fourth pixel PX4, the separation distances between the pixel electrodes AE1, AE2, and AE3 and the holes OPT1, OPT2, and OPT3 of the first light blocking layer BM1 may be about equal to each other. However, in the first pixel PX1 and the second pixel PX2, the separation distances between the pixel electrodes AE1, AE2, and AE3 and the holes OPT1, OPT2, and OPT3 of the first light blocking layer BM1 may be different from each other. In an embodiment, the separation distance between the pixel electrodes AE1, AE2, and AE3 and the holes OPT1, OPT2, and OPT3 of the first light blocking layer BM1 in the first pixel PX1 and the third pixel PX3 may be greater than the separation distance between the pixel electrodes AE1, AE2, and AE3 and the holes OPT1, OPT2, and OPT3 of the first light blocking layer BM1 in the second pixel PX2 and the fourth pixel PX4. In the second pixel PX2 and the fourth pixel PX4, the difference in diameter between the pixel electrodes AE1, AE2, and AE3 and the holes OPT1, OPT2, and OPT3 of the first light blocking layer BM1 may be small, and the outer side of the pixel electrodes AE1, AE2, and AE3 and the inner side of the holes OPT1, OPT2, and OPT3 may be positioned adjacent to each other in a plan view.

The display device 10 may include a first type pixel such as the first pixel PX1 and the third pixel PX3, and a second type pixel such as the second pixel PX2 and the fourth pixel PX4. The first type pixel and the second type pixel may be distinguished not only by the separation distance between the pixel electrodes AE1, AE2, and AE3 and the holes OPT1, OPT2, and OPT3 of the first light blocking layer BM1, but also by whether the second light blocking layer BM2, which is described further below, is disposed. For example, in an embodiment, the second light blocking layer BM2 is not disposed in the first pixel PX1 and the third pixel PX3, and the second light blocking layer BM2 is disposed in the second pixel PX2 and the fourth pixel PX4. The second light blocking layer BM2 may surround corresponding pixel electrodes AE1, AE2, and AE3 in some of the pixels (e.g., PX2 and PX4 in the above example), but not in all of the pixels (e.g., PX2 and PX3 in the above example). The second light blocking layer BM2 will be described in further detail below.

The plurality of color filters CF1, CF2, and CF3 may be respectively disposed to correspond to the pixel electrodes AE1, AE2, and AE3. For example, the color filters CF1, CF2, and CF3 may be disposed on the first light blocking layer BM1 and may be disposed to correspond to the plurality of holes OPT1, OPT2, and OPT3 in the first light blocking layer BM1. The hole OPT1, OPT2, OPT3 of the first light blocking layer BM1 may be formed to overlap the opening of the pixel defining layer PDL (see FIG. 8), and may form a light exit area through which light emitted from the emission area is emitted. Each of the color filters CF1, CF2, and CF3 may have a larger area than the hole OPT1, OPT2, OPT3 of the first light blocking layer BM1, and each of the color filters CF1, CF2, and CF3 may completely cover the light exit area formed by the hole OPT1, OPT2, OPT3. Each of the color filters CF1, CF2, and CF3 may completely cover the hole OPT1, OPT2, OPT3 of the first light blocking layer BM1, and a portion thereof may be directly disposed on the first light blocking layer BM1.

The color filters CF1, CF2, and CF3 may include the first color filter CF1, the second color filter CF2, and the third color filter CF3 disposed to correspond to the different pixel electrodes AE1, AE2, and AE3, respectively. The color filters CF1, CF2, and CF3 may include a colorant such as a dye or pigment that absorbs light in a wavelength band different from light in a specific wavelength band, and may be disposed to correspond to the color of light emitted by a light emitting element including the pixel electrodes AE1, AE2, and AE3. For example, the first color filter CF1 may be a red color filter that is disposed to overlap the first pixel electrode AE1 and transmits only the first light of the red color. The second color filter CF2 may be a green color filter that is disposed to overlap the second pixel electrode AE2 and transmits only the second light of the green color, and the third color filter CF3 may be a blue color filter that is disposed to overlap the third pixel electrode AE3 and transmits only the third light of the blue color.

Similar to the disposition of the pixel electrodes AE1, AE2, and AE3, the color filters CF1, CF2, and CF3 may be disposed in a PenTile^{™} type, e.g., a diamond PenTile^{™} type. For example, the first color filter CF1 and the third color filter CF3 may be alternately arranged in the first direction DR1 and the second direction DR2. The second color filter CF2 and another adjacent second color filter CF2 may be arranged in the first direction DR1 and the second direction DR2, and the second color filter CF2 and an adjacent first color filter CF1 and an adjacent third color filter CF3 may be arranged in the fourth direction DR4 or the fifth direction DR5. The plurality of second color filters CF2 may be repeatedly arranged along the first direction DR1 and the second direction DR2, and the second color filter CF2 and the first color filter CF1, or the second color filter CF2 and the third color filter CF3, may be alternately arranged along the fourth direction DR4 or the fifth direction DR5.

According to an embodiment, the plurality of color filters CF1, CF2, and CF3 may have different areas in a plan view. As described above, the areas of the plurality of pixel electrodes AE1, AE2, and AE3 may be different from each other, and accordingly, the sizes of the holes OPT1, OPT2, and OPT3 of the first light blocking layer BM1, and the areas of the color filters CF1, CF2, and CF3 in a plan view, may also be different from each other. For example, the area of the first color filter CF1, which is a red color filter, may be larger than the areas of the second color filter CF2, which is a green color filter, and the third color filter CF3, which is a blue color filter. Additionally, the area of the third color filter CF3 may be larger than the area of the second color filter CF2. The shape of the color filters CF1, CF2, and CF3 in a plan view may be a circular shape similar to the shape of the pixel electrodes AE1, AE2, and AE3. However, the present disclosure is not limited thereto, and the color filters CF1, CF2, and CF3 may have a rectangular shape or a rhombic shape in a plan view. The display device 10 according to an embodiment may be designed such that the planar shape and area of the color filters CF1, CF2, and CF3 allow external light of the display device 10 to have a specific color.

In an embodiment, the planar area ratio of the first color filter CF1 and the second color filter CF2 may be in a range of about 1:0.3 to about 1:0.7, and the area ratio of the first color filter CF1 and the third color filter CF3 may be in a range of about 1:0.4 to about 1:1. For example, the area ratio of the first color filter CF1, the second color filter CF2, and the third color filter CF3 may be about 1:0.59:0.52 or about 1:0.59:1. However, the area ratio of the color filters CF1, CF2, and CF3 is not limited to the above-described ratios, and the planar areas of the color filters CF1, CF2, and CF3 may be designed differently such that the reflected light in the display device 10 and the electronic device 1 has desired color coordinates.

The display device 10 may include the color filters CF1, CF2, and CF3 disposed on the display layer DU, which may reduce the intensity of reflected light caused by external light. Furthermore, the color of the reflected light by the external light may be controlled by adjusting the disposition, shape, and area of the color filters CF1, CF2, and CF3 in a plan view. A detailed description thereof will be provided below.

A touch electrode TL may be disposed between the pixel electrodes AE1, AE2, and AE3. The touch electrode TL may be disposed to extend in the fourth direction DR4 and the fifth direction DR5, and may be spaced apart from the pixel electrodes AE1, AE2, and AE3. The touch electrode TL may be disposed to overlap the pixel defining layer PDL (see FIG. 8) and the first light blocking layer BM1. The touch electrode TL may include a touch driving electrode and a sensing electrode.

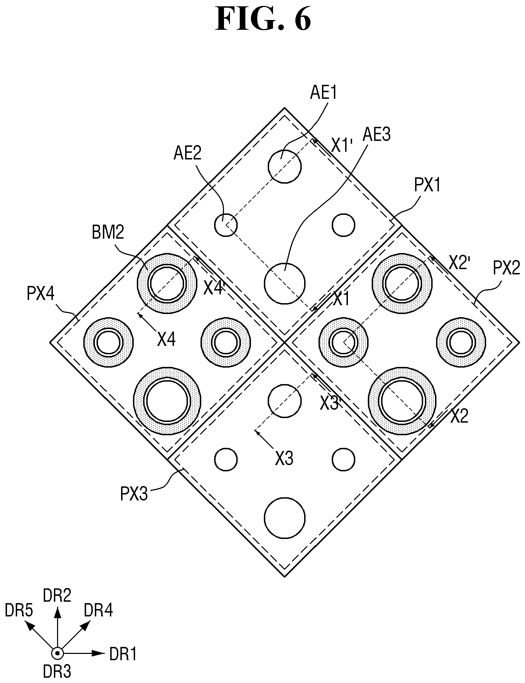

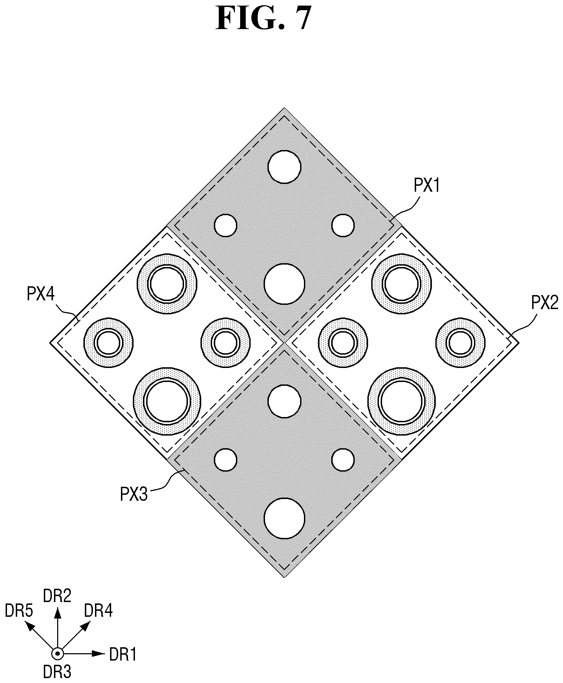

FIG. 6 is a plan view illustrating the disposition of a pixel electrode and a second light blocking layer in the display area of the display device according to an embodiment. FIG. 7 is a schematic diagram illustrating light emitting pixels according to an emission mode of the display device according to an embodiment. FIG. 7 schematically illustrates light emitting pixels in an emission mode with limited side visibility among the emission modes of the display device 10.

Referring to FIGS. 6 and 7, the display device 10 according to an embodiment may include the second light blocking layer BM2. The second light blocking layer BM2 may be disposed only on some of the plurality of pixels in the display area DA. For example, the second light blocking layer BM2 may be disposed in a second type pixel among the plurality of pixels PX, for example, the second pixel PX2 and the fourth pixel PX4. As described above, the plurality of pixels PX may include two types of pixels with different separation distances between the pixel electrodes AE1, AE2, and AE3 and the holes OPT1, OPT2, and OPT3 of the first light blocking layer BM1, and the second light blocking layer BM2 may be disposed only in the second type pixel.

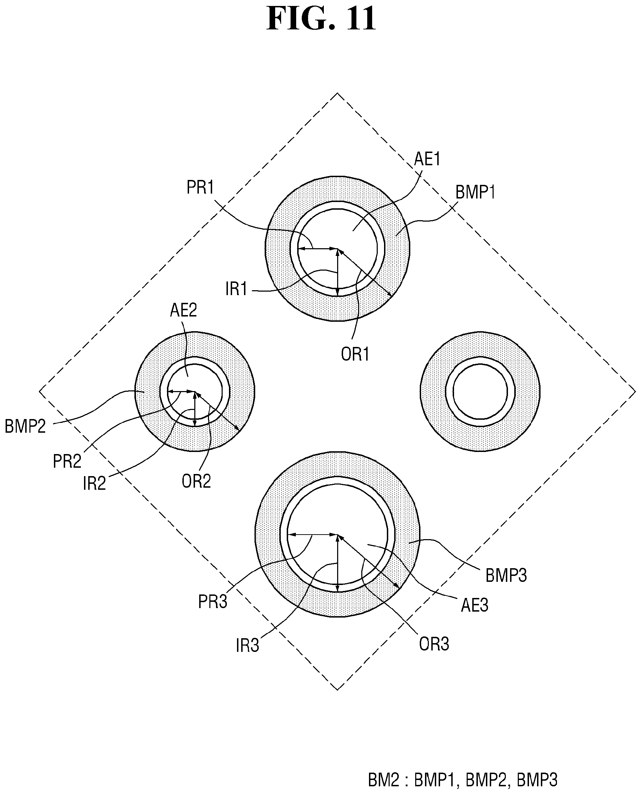

The second light blocking layer BM2 may include a plurality of light blocking patterns BMP1, BMP2, and BMP3 (see FIG. 11), and the light blocking patterns may be disposed to correspond to the plurality of pixel electrodes AE1, AE2, and AE3, respectively. For example, the light blocking patterns may have a uniform/constant width and surround the pixel electrodes AE1, AE2, and AE3 in a plan view, respectively, but may be disposed not to overlap the pixel electrodes AE1, AE2, and AE3. The light blocking patterns do not cover the pixel electrodes AE1, AE2, and AE3 in a plan view, and may have a circular ring shape surrounding them. Similar to the holes OPT1, OPT2, and OPT3 of the first light blocking layer BM1, the inner side of the light blocking patterns may be spaced apart from the outer side of the pixel electrodes AE1, AE2, and AE3 in a plan view.

In the display device 10 according to an embodiment, the plurality of pixels PX include the first type pixel in which the second light blocking layer BM2 is not disposed and the second type pixel in which the second light blocking layer BM2 is disposed. As a result, side visibility may be adjusted depending on the emission mode. Depending on the viewing angle of the display device 10, the light blocking patterns of the second light blocking layer BM2 may partially cover the pixel electrodes AE1, AE2, and AE3 and block the emission of light at a specific viewing angle.

For example, in a first emission mode of the display device 10, both the first type pixel and the second type pixel may emit light in a state in which side visibility is not limited. For example, as illustrated in FIG. 6, when all the first to fourth pixels PX1, PX2, PX3, and PX4 emit light in the first emission mode, regardless of which direction the display device 10 is viewed from, the light emitted from at least both the first pixel PX1 and the third pixel PX3 may be visually recognized by the user.

On the other hand, in a second emission mode of the display device 10, only the second type pixel may emit light in a state in which side visibility is to be limited. For example, as illustrated in FIG. 7, when only the second pixel PX2 and the fourth pixel PX4 emit light in the second emission mode, light emitted from the holes OPT1, OPT2, and OPT3 of the first light blocking layer BM1 may be blocked by the second light blocking layer BM2 at a specific viewing angle. In an embodiment, since the first pixel PX1 and the third pixel PX3 do not emit light, the display screen of the display device 10 may be visually recognized by only the user looking from the front surface of the display area DA in the second emission mode, and the display screen is not visually recognized by the user looking at a specific viewing angle or from the side. For example, the display device 10 may provide a privacy protection mode to the user.

In the second emission mode of the display device 10, light leakage of the emitted light may occur depending on the degree in which the pixel electrodes AE1, AE2, and AE3 of the second pixel PX2 and the fourth pixel PX4 are obscured by the second light blocking layer BM2. However, in the display device 10 according to an embodiment, the light blocking patterns of the second light blocking layer BM2 may be disposed to correspond to the shape of the pixel electrodes AE1, AE2, and AE3 and surround the pixel electrodes AE1, AE2, and AE3 with a uniform/constant width. The display device 10 may have a uniform degree in which the pixel electrodes AE1, AE2, and AE3 of the second type pixel are obscured at all viewing angles looking at the display device 10 in the second emission mode. Thus, embodiments may prevent light leakage of light emitted from light emitting elements including the specific pixel electrodes AE1, AE2, and AE3.

Further, in the display device 10, as light blocking members of the second light blocking layer BM2 are disposed to correspond to the pixel electrodes AE1, AE2, and AE3 of the second type pixel, the light blocking members may be disposed not to invade another adjacent pixel, for example, the first type pixel, and thus may not obscure the pixel electrode of the first type pixel in the first emission mode. That is, in the display device 10, the disposition of the pixel structure may be freely designed although a high-resolution display device is implemented.

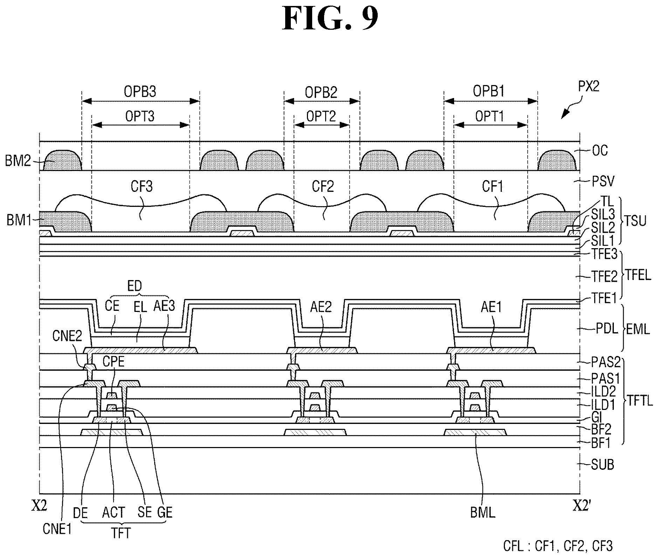

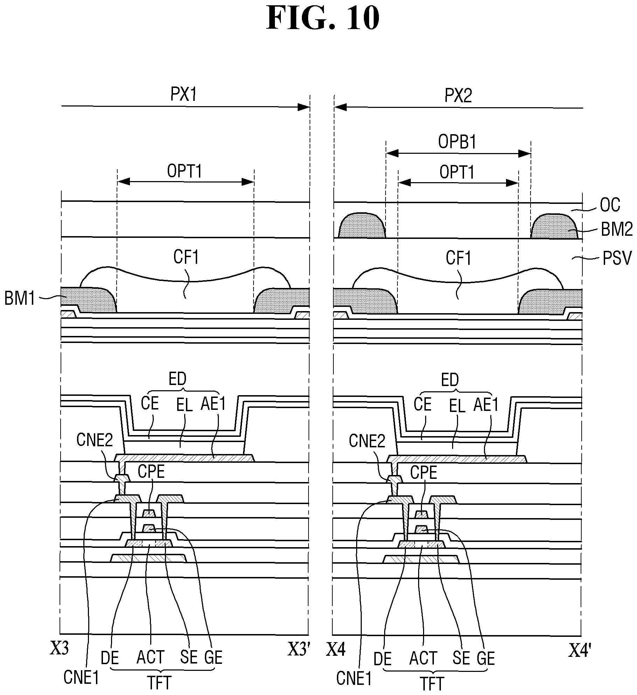

FIG. 8 is a cross-sectional view taken along line X1-X1' of FIGS. 5 and 6. FIG. 9 is a cross-sectional view taken along line X2-X2' of FIGS. 5 and 6. FIG. 10 is a cross-sectional view taken along lines X3-X3' and X4-X4' of FIGS. 5 and 6.

FIG. 8 illustrates a cross section crossing the first to third pixel electrodes AE1, AE2, and AE3 in the first pixel PX1 as the first type pixel, and FIG. 9 illustrates a cross section crossing the first to third pixel electrodes AE1, AE2, and AE3 in the second pixel PX2 as the second type pixel. FIG. 10 illustrates a cross section crossing the first pixel electrode AE1 of the first type pixel and the first pixel electrode AE1 of the second type pixel.

A cross-sectional structure of the display device 10 will be described with reference to FIGS. 8 to 10. The display panel 100 of the display device 10 may include the display layer DU, the touch sensing layer TSU, the first light blocking layer BM1, the color filter layer CFL, and the second light blocking layer BM2. The display layer DU may include the substrate SUB, the thin film transistor layer TFTL, the light emitting element layer EML, and the encapsulation layer TFEL. The first light blocking layer BM1 may be disposed on the touch sensing layer TSU of the display panel 100, and the color filters CF1, CF2, and CF3 of the color filter layer CFL may be disposed on the first light blocking layer BM1. The second light blocking layer BM2 may be disposed on a passivation layer PSV disposed on the color filter layer CFL, and an overcoat layer OC may be disposed on the second light blocking layer BM2.

The substrate SUB may be a base substrate or a base member. The substrate SUB may be a flexible substrate which can be bent, folded or rolled. For example, the substrate SUB may include a polymer resin such as polyimide (PI), but is not limited thereto. For another example, the substrate SUB may include a glass material or a metal material.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2.

The first buffer layer BF1 may be disposed on the substrate SUB. The first buffer layer BF1 may include an inorganic layer capable of preventing penetration of air or water. For example, the first buffer layer BF1 may include a plurality of inorganic layers alternately stacked.

The lower metal layer BML may be disposed on the first buffer layer BF1. For example, the lower metal layer BML may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second buffer layer BF2 may cover the first buffer layer BF1 and the lower metal layer BML. The second buffer layer BF2 may include an inorganic layer capable of preventing penetration of air or water. For example, the second buffer layer BF2 may include a plurality of inorganic layers alternately stacked.

The thin film transistor TFT may be disposed on the second buffer layer BF2, and may constitute a pixel circuit of each of a plurality of pixels. For example, the thin film transistor TFT may be a switching transistor or a driving transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction, and may be insulated from the gate electrode GE by the gate insulating layer Gl. In a part of the semiconductor layer ACT, a material of the semiconductor layer ACT may be made into a conductor to form the source electrode SE and the drain electrode DE.

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. For example, the gate insulating layer GI may cover the semiconductor layer ACT and the second buffer layer BF2 to insulate the gate electrode GE from the semiconductor layer ACT. The gate insulating layer GI may include a contact hole through which the first connection electrode CNE1 passes.

The first interlayer insulating layer ILD1 may cover the gate electrode GE and the gate insulating layer Gl. The first interlayer insulating layer ILD1 may include a contact hole through which the first connection electrode CNE1 passes. The contact hole of the first interlayer insulating layer ILD1 may be connected to the contact hole of the gate insulating layer GI and the contact hole of the second interlayer insulating layer ILD2.

The capacitor electrode CPE may be disposed on the first interlayer insulating layer ILD1. The capacitor electrode CPE may overlap the gate electrode GE in the thickness direction. The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may include a contact hole through which the first connection electrode CNE1 passes. The contact hole of the second interlayer insulating layer ILD2 may be connected to the contact hole of the first interlayer insulating layer ILD1 and the contact hole of the gate insulating layer Gl.

The first connection electrode CNE1 may be disposed on the second interlayer insulating layer ILD2. The first connection electrode CNE1 may electrically connect the drain electrode DE of the thin film transistor TFT to the second connection electrode CNE2. The first connection electrode CNE1 may be inserted into a contact hole provided in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be disposed on the first passivation layer PAS1. The second connection electrode CNE2 may electrically connect the first connection electrode CNE1 to a pixel electrode AE of the light emitting element ED. The second connection electrode CNE2 may be inserted into a contact hole formed in the first passivation layer PAS1 to be in contact with the first connection electrode CNE1.

The second passivation layer PAS2 may cover the second connection electrode CNE2 and the first passivation layer PAS1. The second passivation layer PAS2 may include a contact hole through which the pixel electrode AE of the light emitting element ED passes.

The light emitting element layer EML may be disposed on the thin film transistor layer TFTL. The light emitting element layer EML may include the light emitting element ED and the pixel defining layer PDL. The light emitting element ED may include the pixel electrodes AE1, AE2, and AE3, a light emitting layer EL, and a common electrode CE.

The pixel electrodes AE1, AE2, and AE3 may be disposed on the second passivation layer PAS2. Each of the different pixel electrodes AE1, AE2, and AE3 may be disposed to overlap one of the different openings of the pixel defining layer PDL. The pixel electrodes AE1, AE2, and AE3 may be electrically connected to the drain electrode DE of the thin film transistor TFT through the first and second connection electrodes CNE1 and CNE2.

The light emitting layer EL may be disposed on the pixel electrodes AE1, AE2, and AE3. For example, the light emitting layer EL may be an organic light emitting layer made of an organic material, but is not limited thereto. In the case of employing the organic light emitting layer as the light emitting layer EL, the thin film transistor TFT applies a predetermined voltage to the pixel electrodes AE1, AE2, and AE3 of the light emitting element ED, and if the common electrode CE of the light emitting element ED receives a common voltage or a cathode voltage, the holes and electrons can move to the light emitting layer EL through the hole transporting layer and the electron transporting layer and combine to produce light to be emitted by the light emitting layer EL.

In an embodiment, the light emitting layers EL disposed on different pixel electrodes AE1, AE2, and AE3 may emit light of different colors. For example, the light emitting layer disposed on the first pixel electrode AE1 may emit red light of the first color, the light emitting layer disposed on the second pixel electrode AE2 may emit green light of the second color, and the light emitting layer disposed on the third pixel electrode AE3 may emit blue light of the third color. However, the present disclosure is not limited thereto. In an embodiment, the light emitting layer EL may be disposed as one common layer on the different pixel electrodes AE1, AE2, and AE3 and the pixel defining layer PDL, or the light emitting layer EL disposed on the different pixel electrodes AE1, AE2, and AE3 may emit light of the same color. In this case, the display device 10 may further include a color adjustment layer disposed on the light emitting elements ED.

The common electrode CE may be arranged on the light emitting layer EL. For example, the common electrode CE may be made in the form of an electrode common to all of the pixels rather than specific to each of the pixels. The common electrode CE may be disposed on the light emitting layer EL in the first to third pixel electrodes AE1, AE2, and AE3, and may be disposed on the pixel defining layer PDL in an area other than the first to third pixel electrodes AE1, AE2, and AE3.

The common electrode CE may receive the common voltage or a low potential voltage. When the pixel electrode AE receives a voltage corresponding to a data voltage and the common electrode CE receives the low potential voltage, a potential difference is formed between the pixel electrodes AE1, AE2, and AE3 and the common electrode CE, so that the light emitting layer EL may emit light.

The pixel defining layer PDL may include a plurality of openings and may be disposed on a part of the pixel electrodes AE1, AE2, and AE3 and the second passivation layer PAS2. Each opening of the pixel defining layer PDL may expose a part of the pixel electrodes AE1, AE2, and AE3. As described above, the respective openings of the pixel defining layer PDL may define the first to third emission areas, and the areas or sizes thereof may be different from each other. The pixel defining layer PDL may separate and insulate the pixel electrodes AE1, AE2, and AE3 of each of the plurality of light emitting elements ED. The pixel defining layer PDL may include a light absorbing material, which may prevent light reflection. For example, the pixel defining layer PDL may include a polyimide (PI)-based binder and a pigment in which red, green, and blue colors are mixed. Alternatively, the pixel defining layer PDL may include a cardo-based binder resin and a mixture of a lactam black pigment and a blue pigment. Alternatively, the pixel defining layer PDL may include carbon black.

The encapsulation layer TFEL may be disposed on the common electrode CE to cover the plurality of light emitting elements ED. The encapsulation layer TFEL may include at least one inorganic layer, which may prevent oxygen or moisture from penetrating into the light emitting element layer EML. The encapsulation layer TFEL may include at least one organic layer, which may protect the light emitting element layer EML from foreign matters such as dust.

In an embodiment, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2, which may be disposed between the first encapsulation layer TFE1 and the third encapsulation layer TFE3, may be an organic encapsulation layer.

Each of the first encapsulation layer TFE1 and the third encapsulation layer TFE3 may include one or more inorganic insulating materials. The inorganic insulating material may include, for example, aluminum oxide, titanium oxide, tantalum oxide, hafnium oxide, zinc oxide, silicon oxide, silicon nitride, and/or silicon oxynitride.

The second encapsulation layer TFE2 may include a polymer-based material. Examples of the polymer-based material may include acrylic resin, epoxy resin, polyimide, polyethylene and the like. For example, the organic encapsulation layer 320 may include an acrylic resin, for example, polymethyl methacrylate, polyacrylic acid, or the like. The second encapsulation layer TFE2 may be formed by curing a monomer or applying a polymer.

The touch sensing layer TSU may be disposed on the encapsulation layer TFEL. The touch sensing layer TSU may include a first touch insulating layer SIL1, a second touch insulating layer SIL2, the touch electrode TL, and a third touch insulating layer SIL3.

The first touch insulating layer SIL1 may be disposed on the encapsulation layer TFEL. The first touch insulating layer SIL1 may have an insulating and optical function. The first touch insulating layer SIL1 may include at least one inorganic layer. In an embodiment, the first touch insulating layer SIL1 may be omitted.

The second touch insulating layer SIL2 may cover the first touch insulating layer SIL1. In an embodiment, a touch electrode of another layer may be further disposed on the first touch insulating layer SIL1, and the second touch insulating layer SIL2 may cover the touch electrode TL. The second touch insulating layer SIL2 may have an insulating and optical function. For example, the second touch insulating layer SIL2 may be an inorganic layer containing at least one of a silicon nitride layer, a silicon oxynitride layer, a silicon oxide layer, a titanium oxide layer, or an aluminum oxide layer.

A part of the touch electrode TL may be disposed on the second touch insulating layer SIL2. In an embodiment, the touch electrode TL does not overlap the first to third pixel electrodes AE1, AE2, and AE3. The touch electrode TL may be formed of a single layer containing, for example, molybdenum (Mo), titanium (Ti), copper (Cu), aluminum (Al), or indium tin oxide (ITO), or may be formed to have a stacked structure (Ti/Al/Ti) of aluminum and titanium, a stacked structure (ITO/AI/ITO) of aluminum and ITO, an Ag-Pd-Cu (APC) alloy, or a stacked structure (ITO/APC/ITO) of APC alloy and ITO.

The touch electrode TL of the touch sensing layer TSU may have a constant line width and may be disposed to overlap the first light blocking layer BM1, which will be described further below. The first light blocking layer BM1 may have a width sufficient to completely cover the touch electrode TL, and a gap between an edge of the first light blocking layer BM1 and the touch electrode TL may be defined. In an embodiment, the line width of the touch electrode TL may be in a range of about 4 µm to about 6 µm, and the gap between the touch electrode TL and the edge of the first light blocking layer BM1 may be in a range of about 5 µm to about 7 µm. The touch electrode TL may be disposed such that the center thereof is substantially parallel to the center of the first light blocking layer BM1, and the gap from both sides of the touch electrode TL to the edge of the first light blocking layer BM1 may be approximately constant.

The third touch insulating layer SIL3 may cover the touch electrode TL and the second touch insulating layer SIL2. The third touch insulating layer SIL3 may have an insulating and optical function. The third touch insulating layer SIL3 may be made of the material exemplified in association with the second touch insulating layer SIL2.

The first light blocking layer BM1 may be disposed on the third touch insulating layer SIL3 of the touch sensing layer TSU. The first light blocking layer BM1 may be disposed to cover the conductive line of the touch electrode TL, while including the plurality of holes OPT1, OPT2, and OPT3 that overlap the pixel electrodes AE1, AE2, and AE3. For example, the first hole OPT1 may be disposed to overlap the first pixel electrode AE1, the second hole OPT2 may be disposed to overlap the second pixel electrode AE2, and the third hole OPT3 may be disposed to overlap the third pixel electrode AE3. The areas or sizes of the holes OPT1, OPT2, and OPT3 may be larger than the areas or sizes of the pixel electrodes AE1, AE2, and AE3. Further, the area or size of each of the holes OPT1, OPT2, and OPT3 may be formed to be larger than the openings of the pixel defining layer PDL, and the light emitted from the light emitting element ED may be visually recognized by the user not only from the front, but also from the side of the display device 10.

The first light blocking layer BM1 may include a light absorbing material. For example, the first light blocking layer BM1 may include an inorganic black pigment or an organic black pigment. The inorganic black pigment may be carbon black, and the organic black pigment may include at least one of, for example, lactam black, perylene black, or aniline black, but embodiments are not limited thereto. The first light blocking layer BM1 may prevent visible light infiltration and color mixture between the holes OPT1, OPT2, and OPT3, which may improve color reproducibility of the display device 10. In an embodiment, the first light blocking layer BM1 may have a thickness of about 1 µm to about 3 µm, and in an embodiment, may have a thickness of about 1.5 µm.

In an embodiment, the size of the holes OPT1, OPT2, and OPT3 of the first light blocking layer BM1 disposed to overlap the first type pixel may be larger than the size of the holes OPT1, OPT2, and OPT3 of the first light blocking layer BM1 disposed to overlap the second type pixel. As illustrated in FIG. 10, the size of the first hole OPT1 overlapping the first pixel electrode AE1 of the first type pixel (or the first pixel PX1) may be larger than the size of the first hole OPT1 overlapping the first pixel electrode AE1 of the second type pixel (or the second pixel PX2). As described above, in an embodiment, in the second emission mode of the display device 10, the first type pixel does not emit light, and only the second type pixel may emit light. When the second type pixel emits light, the size of the holes OPT1, OPT2, and OPT3 of the first light blocking layer BM1 may be relatively small, which may block light from exiting at a specific viewing angle. Further, since the second light blocking layer BM2 is disposed in the second type pixel, the second emission mode of the display device 10 may control the side visibility of light emitted from the second type pixel.

The color filters CF1, CF2, and CF3 of the color filter layer CFL may be disposed on the first light blocking layer BM1. The different color filters CF1, CF2, and CF3 may be disposed to correspond to the different pixel electrodes AE1, AE2, and AE3 and the holes OPT1, OPT2, and OPT3 of the first light blocking layer BM1, respectively. For example, the first color filter CF1 may be disposed to correspond to the first pixel electrode AE1, the second color filter CF2 may be disposed to correspond to the second pixel electrode AE2, and the third color filter CF3 may be disposed to correspond to the third pixel electrode AE3. The first color filter CF1 may be disposed in the first hole OPT1 of the first light blocking layer BM1, the second color filter CF2 may be disposed in the second hole OPT2 of the first light blocking layer BM1, and the third color filter CF3 may be disposed in the third hole OPT3 of the first light blocking layer BM1. Each of the color filters CF1, CF2, and CF3 may be disposed to have a larger area in a plan view than the hole OPT1, OPT2, OPT3 of the first light blocking layer BM1, and a part thereof may be disposed directly on the first light blocking layer BM1.

The passivation layer PSV may be disposed on the first light blocking layer BM1 and the color filter layer CFL. The passivation layer PSV may be disposed over the entire display area DA, and may flatten the top surface of the display panel 100. The passivation layer PSV may be a colorless light transmissive layer that does not have a color in a visible light band. For example, the overcoat layer OC may include a colorless light transmissive organic material such as an acrylic resin.

The second light blocking layer BM2 may be disposed on the passivation layer PSV. In an embodiment, the second light blocking layer BM2 is not disposed in the first type pixel (or the first pixel PX1), but may be disposed only in the second type pixel (or the second pixel PX2). The second light blocking layer BM2 may be disposed to correspond the periphery of the pixel electrodes AE1, AE2, and AE3 of the second type pixel, and may form transmission portions OPB1, OPB2, and OPB3 formed to overlap the pixel electrodes AE1, AE2, and AE3. For example, the second light blocking layer BM2 may include the first transmission portion OPB1 overlapping the first pixel electrode AE1, the second transmission portion OPB2 overlapping the second pixel electrode AE2, and the third transmission portion OPB3 overlapping the third pixel electrode AE3. The transmission portions OPB1, OPB2, and OPB3 may overlap the holes OPT1, OPT2, and OPT3 of the first light blocking layer BM1, respectively.

In an embodiment, the diameter or area in a plan view of the transmission portions OPB1, OPB2, and OPB3 of the second light blocking layer BM2 may be larger than the diameter or area in a plan view of the holes OPT1, OPT2, and OPT3 of the first light blocking layer BM1, and the pixel electrodes AE1, AE2, and AE3. Light emitted from the light emitting element ED including the pixel electrodes AE1, AE2, and AE3 may be emitted through the holes OPT1, OPT2, and OPT3 of the first light blocking layer BM1 and the transmission portions OPB1, OPB2, and OPB3 of the second light blocking layer BM2. The light emitted from the second type pixel is finally emitted after passing through the transmission portions OPB1, OPB2, and OPB3, and a large amount of light may be visually recognized at least when the display device 10 is viewed from the front.

However, when the display device 10 is viewed from the side, the light emitted from the second type pixel may be obscured by the second light blocking layer BM2, although the light passes through the holes OPT1, OPT2, and OPT3 of the first light blocking layer BM1. That is, the display device 10 may control visibility at a specific viewing angle and provide a privacy protection mode to the user by causing only the second type pixel or the second pixel PX2 on which the second light blocking layer BM2 is disposed to emit light in the second emission mode.

The second light blocking layer BM2 may include a light absorbing material. For example, the second light blocking layer BM2 may include an inorganic black pigment or an organic black pigment. The inorganic black pigment may be carbon black, and the organic black pigment may include at least one of, for example, lactam black, perylene black, or aniline black, but embodiments are not limited thereto. In an embodiment, the second light blocking layer BM2 may have a thickness of about 1 µm to about 3 µm, and in an embodiment, may have a thickness of about 1.5 µm.

The overcoat layer OC may be disposed on the second light blocking layer BM2 and the passivation layer PSV. The overcoat layer OC may be disposed over the entire display area DA, and may flatten the top surface of the display panel 100. The overcoat layer OC may be a colorless light transmissive layer that does not have a color in a visible light band. For example, the overcoat layer OC may include a colorless light transmissive organic material such as an acrylic resin.

Hereinafter, the second light blocking layer BM2 and the pixel electrodes AE1, AE2, and AE3 of the display device 10 will be described in more detail.

FIG. 11 is a diagram illustrating the relative disposition of a second light blocking layer and a pixel electrode disposed in one pixel of the display device according to an embodiment. FIG. 11 illustrates an example of the second type pixel, or the second pixel PX2, in which the second light blocking layer BM2 is disposed.

Referring to FIG. 11, in the display device 10, diameters PR1, PR2, and PR3 of the different pixel electrodes AE1, AE2, and AE3 may be different from each other. For example, the diameter PR3 of the third pixel electrode AE3 may be larger than the diameters PR1 and PR2 of the first pixel electrode AE1 and the second pixel electrode AE2. The diameter PR1 of the first pixel electrode AE1 may be larger than the diameter PR2 of the second pixel electrode AE2. For example, the area of the pixel electrodes AE1, AE2, and AE3 may be designed in consideration of the wavelength of light emitted from the light emitting element ED including each of the pixel electrodes AE1, AE2, and AE3, the lifespan of the light emitting element ED, and the like.

The second light blocking layer BM2 may include the light blocking patterns BMP1, BMP2, and BMP3 corresponding to the pixel electrodes AE1, AE2, and AE3 and surrounding the pixel electrodes AE1, AE2, and AE3 in a plan view, respectively. For example, the second light blocking layer BM2 may include a first light blocking pattern BMP1 surrounding the first pixel electrode AE1, a second light blocking pattern BMP2 surrounding the second pixel electrode AE2, and a third light blocking pattern BMP3 surrounding the third pixel electrode AE3. In the same manner as the number and disposition of the pixel electrodes AE1, AE2, and AE3 included in one pixel PX, one pixel PX may include one first light blocking pattern BMP1, two second light blocking patterns BMP2, and one third light blocking pattern BMP3, which may be spaced apart from each other in a diagonal direction. However, the present disclosure is not limited thereto.

The plurality of light blocking patterns BMP1, BMP2, and BMP3 of the second light blocking layer BM2 may have the same width and may be disposed to surround the pixel electrodes AE1, AE2, and AE3. The light blocking patterns BMP1, BMP2, and BMP3 may form the transmission portions OPB1, OPB2, and OPB3 (see FIG. 9) overlapping the pixel electrodes AE1, AE2, and AE3, may have a circular ring shape, and may have inner diameters IR1, IR2, and IR3 and outer diameters OR1, OR2, and OR3 measured from the center of the pixel electrodes AE1, AE2, and AE3.

According to an embodiment, in the plurality of light blocking patterns BMP1, BMP2, and BMP3 of the second light blocking layer BM2, the difference or the separation distance between the inner diameters IR1, IR2, and IR3 and the diameters PR1, PR2, and PR3 of the pixel electrodes AE1, AE2, and AE3 may be uniform. For example, the difference between the inner diameter IR1 of the first light blocking pattern BMP1 and the diameter PR1 of the first pixel electrode AE1 may be about the same as the difference between the inner diameter IR2 of the second light blocking pattern BMP2 and the diameter PR2 of the second pixel electrode AE2, and the difference between the inner diameter IR3 of the third light blocking pattern BMP3 and the diameter PR3 of the third pixel electrode AE3. The light blocking patterns BMP1, BMP2, and BMP3 of the second light blocking layer BM2 may be disposed at a uniform separation distance from the pixel electrodes AE1, AE2, and AE3, regardless of their type. In an embodiment, the separation distance between the light blocking patterns BMP1, BMP2, and BMP3 of the second light blocking layer BM2 and the pixel electrodes AE1, AE2, and AE3 may be in a range of about 1 µm to about 3 µm, and in an embodiment, may be about 1.2 µm.

Although the diameters PR1, PR2, and PR3 of the pixel electrodes AE1, AE2, and AE3 are different from each other, as the separation distances from the pixel electrodes AE1, AE2, and AE3 are uniform, the inner diameters IR1, IR2, and IR3 and the outer diameters OR1, OR2, and OR3 of the light blocking patterns BMP1, BMP2, and BMP3 may be different from each other. For example, the inner diameter IR3 of the third light blocking pattern BMP3 may be larger than the inner diameter IR1 of the first light blocking pattern BMP1 and the inner diameter IR2 of the second light blocking pattern BMP2, and the inner diameter IR1 of the first light blocking pattern BMP1 may be larger than the inner diameter IR2 of the second light blocking pattern BMP2. In addition, the outer diameter OR3 of the third light blocking pattern BMP3 may be larger than the outer diameter OR1 of the first light blocking pattern BMP1 and the outer diameter OR2 of the second light blocking pattern BMP2, and the outer diameter OR1 of the first light blocking pattern BMP1 may be larger than the outer diameter OR2 of the second light blocking pattern BMP2. The size of the light blocking patterns BMP1, BMP2, and BMP3 may be adjusted in various ways depending on the diameter of the pixel electrodes AE1, AE2, and AE3 and the separation distance from the pixel electrodes AE1, AE2, and AE3.

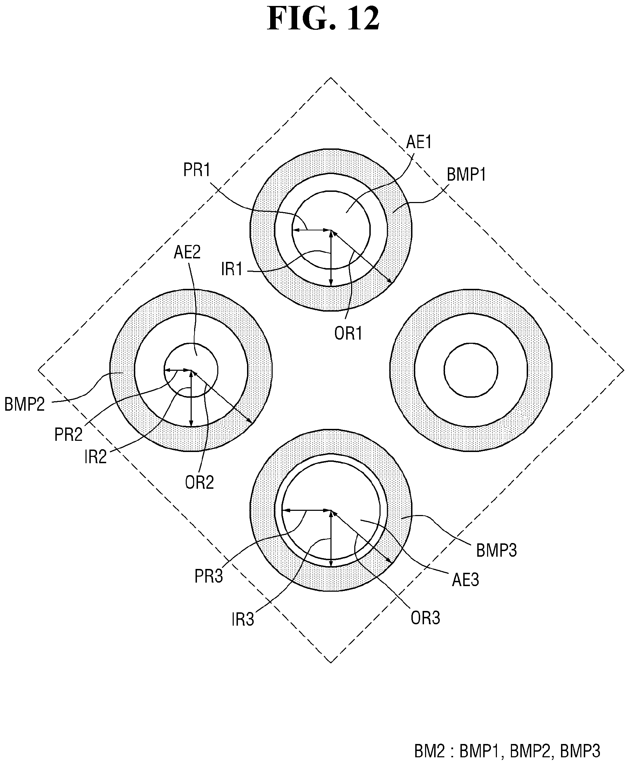

FIG. 12 is a diagram illustrating the relative disposition of a second light blocking layer and a pixel electrode disposed in one pixel of a display device according to an embodiment.

Referring to FIG. 12, in the display device 10 according to an embodiment, the diameters PR1, PR2, and PR3 of the different pixel electrodes AE1, AE2, and AE3 may be different from each other. The plurality of light blocking patterns BMP1, BMP2, and BMP3 of the second light blocking layer BM2 may have about the same width and may be disposed to surround the pixel electrodes AE1, AE2, and AE3. However, unlike an embodiment according to FIG. 11, in the plurality of light blocking patterns BMP1, BMP2, and BMP3 of the second light blocking layer BM2, the differences or the separation distances between the inner diameters IR1, IR2, and IR3 and the diameters PR1, PR2, and PR3 of the pixel electrodes AE1, AE2, and AE3 may be different from each other. For example, the difference between the inner diameter IR3 of the third light blocking pattern BMP3 and the diameter PR3 of the third pixel electrode AE3 may be smaller than the difference between the inner diameter IR1 of the first light blocking pattern BMP1 and the diameter PR1 of the first pixel electrode AE1, and the difference between the inner diameter IR2 of the second light blocking pattern BMP2 and the diameter PR2 of the second pixel electrode AE2. The difference between the inner diameter IR1 of the first light blocking pattern BMP1 and the diameter PR1 of the first pixel electrode AE1 may be smaller than the difference between the inner diameter IR2 of the second light blocking pattern BMP2 and the diameter PR2 of the second pixel electrode AE2. The separation distance between the pixel electrodes AE1, AE2, and AE3 and the light blocking patterns BMP1, BMP2, and BMP3 may be opposite to the order of the diameters PR1, PR2, and PR3 of the pixel electrodes AE1, AE2, and AE3.

As the diameters PR1, PR2, and PR3 of the pixel electrodes AE1, AE2, and AE3 are different from each other and the separation distances from the pixel electrodes AE1, AE2, and AE3 are also different, the inner diameters IR1, IR2, and IR3 and the outer diameters OR1, OR2, and OR3 of the light blocking patterns BMP1, BMP2, and BMP3 may be uniform. For example, the inner diameter IR1 of the first light blocking pattern BMP1 may be about the same as the inner diameter IR2 of the second light blocking pattern BMP2 and the inner diameter IR3 of the third light blocking pattern BMP3. Further, the outer diameter OR1 of the first light blocking pattern BMP1 may be about the same as the outer diameter OR2 of the second light blocking pattern BMP2 and the outer diameter OR3 of the third light blocking pattern BMP3.

The degree to which the pixel electrodes AE1, AE2, and AE3 are obscured by the light blocking patterns BMP1, BMP2, and BMP3 at a specific viewing angle when looking at the display device 10 may be correlated with the separation distance between the pixel electrodes AE1, AE2, and AE3 and the light blocking patterns BMP1, BMP2, and BMP3. In order for light not to be visually recognized when the display device 10 in the second emission mode is viewed from a specific viewing angle, all of the pixel electrodes AE1, AE2, and AE3 are to be obscured regardless of their type at the corresponding viewing angle. When the diameters of the pixel electrodes AE1, AE2, and AE3 are different but the separation distances from the light blocking patterns BMP1, BMP2, and BMP3 are uniform, any one of the pixel electrodes AE1, AE2, and AE3 may be completely obscured at a specific viewing angle while the other pixel electrodes AE1, AE2, and AE3 may not be obscured, so that the light may be visually recognized.

For example, in an embodiment, the second type pixel (hereinafter referred to as the second pixel PX2) is not visually recognized at a viewing angle at which the pixel electrodes AE1, AE2, and AE3 are obscured by the light blocking patterns BMP1, BMP2, and BMP3, respectively. However, in a state where the other pixel electrodes AE1, AE3 are obscured by the light blocking patterns BMP1, BMP2, and BMP3 at a specific viewing angle, the second pixel electrode AE2 with a relatively small diameter is not covered by the light blocking patterns BMP1, BMP2, and BMP3. In this case, the light emitted from the light emitting layer disposed on the second pixel electrode AE2 of the second pixel PX2 may be visually recognized at the corresponding viewing angle. When the light emitting layer disposed on the second pixel electrode AE2 emits green light, a greenish phenomenon in which the display screen has an entirely green color at the corresponding viewing angle may occur.

Further, at a specific viewing angle, the second pixel electrode AE2 that has a relatively small diameter than other pixel electrodes may be obscured by the light blocking patterns BMP1, BMP2, and BMP3 to a relatively large extent. In this case, a relatively little amount of the light emitted from the light emitting layer disposed on the second pixel electrode AE2 of the second pixel PX2 may be visually recognized at the corresponding viewing angle. When the light emitting layer disposed on the second pixel electrode AE2 emits green light, a magenta phenomenon with an entirely purple color may occur in the display screen at the corresponding viewing angle due to a lack of green light.

In consideration of the above, at a viewing angle at which a pixel electrode with a large diameter may be obscured by the light blocking pattern, in order to also obscure a pixel electrode with a small diameter by the light blocking pattern at a similar ratio, the separation distance therebetween may be adjusted. In an embodiment, the separation distances between the pixel electrodes AE1, AE2, and AE3 and the light blocking patterns BMP1, BMP2, and BMP3 may be different from each other, and the differential relationship may be the opposite of the diameter differential relationship of the pixel electrodes AE1, AE2, and AE3.

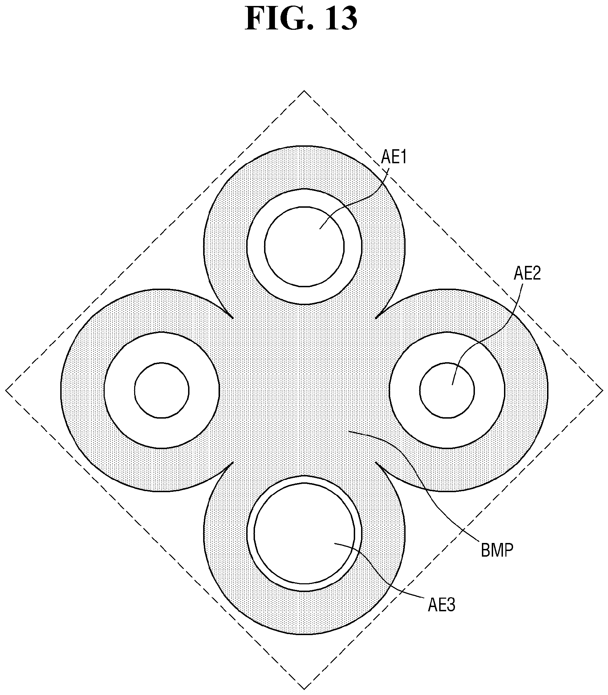

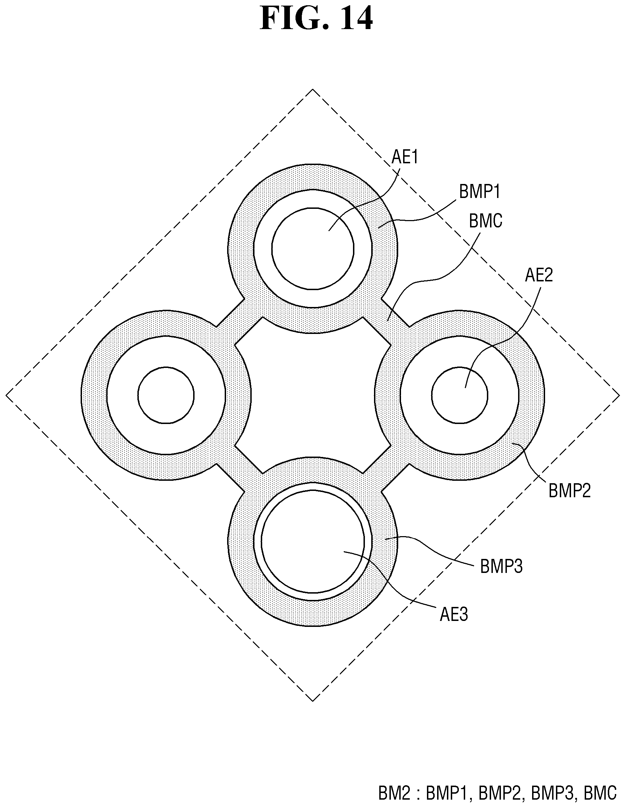

FIGS. 13 and 14 are views showing a second light blocking layer of a display device according to an embodiment.

Referring to FIG. 13, in the second light blocking layer BM2 according to an embodiment, the light blocking patterns BMP1, BMP2, and BMP3 respectively disposed to correspond to and surround the pixel electrodes AE1, AE2, and AE3 may be integrated with each other. Unlike an embodiment according to FIG. 12, in an embodiment according to FIG. 13, the light blocking patterns BMP1, BMP2, and BMP3 are integrated.

The second light blocking layer BM2 may be formed through a patterning process using a mask. In an embodiment, in terms of process, a large pattern integrated with each other may be formed rather than forming a plurality of patterns spaced apart from each other. Accordingly, the display device 10 may include one light blocking pattern BMP disposed to correspond to each second type pixel (or the second pixel PX2), but may have a shape in which the light blocking pattern BMP does not cover the pixel electrodes AE1, AE2, and AE3 and includes the transmission portions OPB1, OPB2, and OPB3 overlapping them.

Referring to FIG. 14, in the second light blocking layer BM2 according to an embodiment, the light blocking patterns BMP1, BMP2, and BMP3 respectively disposed to correspond to and surround the pixel electrodes AE1, AE2, and AE3 may be connected to each other. An embodiment according to FIG. 14 may differ from an embodiment according to FIG. 12 in that the light blocking patterns BMP1, BMP2, and BMP3 are connected through a connection portion BMC. Alternatively, an embodiment according to FIG. 14 may differ from an embodiment according to FIG. 13 in that the center of the light blocking pattern BMP is removed. As described above, in the mask process for forming the second light blocking layer BM2, embodiments may form one large pattern rather than forming a plurality of patterns spaced apart from each other. In addition, embodiments may reduce the area in which the second light blocking layer BM2 is disposed, which may improve color adjustment. The display device 10 may include a shape in which the plurality of light blocking patterns BMP1, BMP2, and BMP3 respectively disposed to correspond to the pixel electrodes AE1, AE2, and AE3 of the second type pixel (or second pixel PX2) are connected to other adjacent patterns through the connection portion BMC.

While the present disclosure has been particularly shown and described with reference to embodiments thereof, it will be understood by those of ordinary skill in the art that various changes in form and detail may be made therein without departing from the scope of the present disclosure as defined by the following claims.

## Claims

1. A display device (10), comprising:
a plurality of pixels (PX1, PX2, PX3, and PX4) disposed in a display area,
wherein each of the plurality of pixels comprises a plurality of pixel electrodes (AE1, AE2, AE3) spaced apart from each other;
a first light blocking layer (BM1) disposed in the display area and comprising a plurality of holes (OPT1, OPT2, OPT3) overlapping the plurality of pixel electrodes (AE1, AE2, and AE3);
a plurality of color filters (CF1, CF2, CF3) disposed on the first light blocking layer and respectively corresponding to a corresponding one of the plurality of holes (OPT1, OPT2, OPT3); and
a second light blocking layer (BM2) disposed on the plurality of color filters and corresponding to each of the plurality of pixel electrodes of a part of the plurality of pixels,
wherein the second light blocking layer (BM2) surrounds each of the corresponding pixel electrodes (AE1, AE2, AE3) of the part of the plurality of pixels in a plan view and comprises a plurality of light blocking patterns (BMP1, BMP2) each having a constant width.

2. The display device (10) of claim 1, wherein the plurality of pixel electrodes comprises a first pixel electrode and a second pixel electrode having a larger diameter than the first pixel electrode,
the second light blocking layer (BM2) comprises a first light blocking pattern (BMP1) corresponding to the first pixel electrode, and a second light blocking pattern (BMP2) corresponding to the second pixel electrode, and
a separation distance between an outer side of the first pixel electrode and an inner side of the first light blocking pattern is equal to a separation distance between an outer side of the second pixel electrode and an inner side of the second light blocking pattern.

3. The display device (10) of claim 2, wherein the separation distance between the outer side of the first pixel electrode and the inner side of the first light blocking pattern (BMP1) ranges from 1 µm to 3 µm.

4. The display device (10) of claim 2 or 3, wherein the first light blocking pattern (BMP1) and the second light blocking pattern (BMP2) have a same width, and
an inner diameter from a center of the first pixel electrode to the inner side of the first light blocking pattern (BMP1) is larger than an inner diameter from a center of the second pixel electrode to the inner side of the second light blocking pattern (BMP2).

5. The display device (10) of any of claims 2 to 4, wherein an outer diameter from the center of the first pixel electrode to an outer side of the first light blocking pattern (BMP1) is larger than an outer diameter from the center of the second pixel electrode to an outer side of the second light blocking pattern (BMP2).

6. The display device (10) of claim 1, wherein the plurality of pixel electrodes comprises a first pixel electrode and a second pixel electrode having a larger diameter than the first pixel electrode,
the second light blocking layer (BM2) comprises a first light blocking pattern (BMP1) corresponding to the first pixel electrode, and a second light blocking pattern (BMP2) corresponding to the second pixel electrode, and
a separation distance between an outer side of the first pixel electrode and an inner side of the first light blocking pattern (BMP1) is different from a separation distance between an outer side of the second pixel electrode and an inner side of the second light blocking pattern (BMP2).

7. The display device (10) of claim 6, wherein the separation distance between the outer side of the first pixel electrode and the inner side of the first light blocking pattern (BMP1) is smaller than the separation distance between the outer side of the second pixel electrode and the inner side of the second light blocking pattern (BMP2).

8. The display device (10) of claim 6 or 7, wherein the first light blocking pattern (BMP1) and the second light blocking pattern (BMP2) have a same width,
an inner diameter from a center of the first pixel electrode to the inner side of the first light blocking pattern is equal to an inner diameter from a center of the second pixel electrode to the inner side of the second light blocking pattern, and
an outer diameter from the center of the first pixel electrode to an outer side of the first light blocking pattern is equal to an outer diameter from the center of the second pixel electrode to an outer side of the second light blocking pattern.

9. The display device (10) of any of the preceding claims, wherein the plurality of light blocking patterns (BMP1, BMP2) are directly connected to each other.

10. The display device (10) of any of the preceding claims, wherein the second light blocking layer (BM2) comprises a transmission portion (OPB1, OPB2, OPB3) overlapping the corresponding pixel electrodes of the part of the plurality of pixels, and
the transmission portion of the second light blocking layer overlaps the holes of the first light blocking layer.

11. The display device (10) of claim 10, wherein a diameter of the transmission portion of the second light blocking layer is larger than a diameter of a corresponding one of the holes of the first light blocking layer.

12. The display device (10) of any of the preceding claims, wherein the plurality of pixels comprise a first pixel in which the second light blocking layer (BM2) is not disposed, and a second pixel in which the first and second light blocking patterns are respectively disposed and correspond to the corresponding one of the plurality of the pixel electrodes.

13. The display device (10) of claim 12, wherein a diameter of one of the holes of the first light blocking layer in the first pixel is larger than a diameter one of the holes of the first light blocking layer in the second pixel.

14. The display device (10) of claim 12 or 13, wherein a difference between a diameter of one of the pixel electrodes (AE1, AE2, AE3) of the first pixel and the diameter of the one of the holes (OPT1, OPT2, OPT3) of the first light blocking layer of the first pixel is greater than a difference between a diameter of one of the pixel electrodes (AE1, AE2, AE3) of the second pixel and the diameter of the one of the holes (OPT1, OPT2, OPT3) of the first light blocking layer of the second pixel.

15. The display device (10) of any of the preceding claims, wherein a thickness of each of the first light blocking layer (BM1) and the second light blocking layer (BM2) ranges from 1 µm to 3 µm.
